# EUROPEAN PATENT APPLICATION

(11) **EP 4 428 911 A1**
(43) Date of publication of application: **11.09.2024**
(21) Application number: 23160460.4
(22) Date of filing: 07.03.2023
(51) Int. Cl.: H01L 23/00, H01L 25/07

(54) **CHIP-TO-CHIP STACKING BY USE OF NICKEL TIN METALLIZATION STACKS AND DIFFUSION SOLDERING**

(71) Applicant: Infineon Technologies Austria AG, 9500 Villach (AT)
(72) Inventor: JAKANADAN, Shalini, 08000 Sungai Petani, Kedah (MY); KOFFLER, Guenther, 10250 Georgetown Pulau Pinang (MY); LIM, Huat Chye, 11060 Penang (MY); OOI, Seng Yeong, 11700 Gelugor, Penang (MY)
(74) Representative: Lambsdorff & Lange Patentanwälte Partnerschaft mbB

(57) **Abstract**

A method for fabricating a semiconductor device comprises comprising
providing a substrate layer stack comprising a substrate with a metallic upper surface, a first Ni containing layer disposed on the substrate, and a first Sn layer on the first Ni containing layer (110);
depositing a first semiconductor layer stack on the first Sn layer, the first semiconductor layer stack comprising a first NiP layer, a first semiconductor die disposed on the first NiP layer, and a second NiP layer disposed on the first semiconductor die (120);
depositing a second semiconductor layer stack on the first semiconductor layer stack, the second semiconductor layer stack comprising
a second Sn layer, a second Ni containing layer disposed on the second Sn layer, and a second semiconductor die disposed on the second Ni containing layer (130); and
performing a diffusion soldering process for connecting the first semiconductor layer stack to the substrate and the second semiconductor layer stack to the first semiconductor layer stack (140).

## Description

### TECHNICAL FIELD

The present disclosure is related to a method for fabricating a semiconductor device, and to a semiconductor device.

### BACKGROUND

In many electronic systems it is necessary to employ voltage or current converters like AC/AC converters, AC/DC converters, DC/AC converters, DC/DC converters, or frequency converters in order to generate the currents, voltages and/or frequencies to be used by an electronic circuit like, for example, a motor driving circuit. The converter circuits as mentioned before typically comprise one or more half-bridge circuits, each provided by two semiconductor power switches, such as e.g. power MOSFET devices, in particular insulated gate bipolar transistor (IGBT) devices, and further components such as diodes connected in parallel to the transistor devices, and passive devices such as resistors, inductors, and capacitors. The switching of the power MOSFET devices can be controlled by one or more semiconductor driver devices.

The assembly of the aforementioned devices can in principle be accomplished by mounting and interconnecting the devices as individual components on a printed circuit board (PCB). There is, however, a general tendency to provide integrated semiconductor modules having short interconnections between the devices in order to reduce switching losses and parasitic inductances. Such already known typical semiconductor modules comprise a carrier, at least one semiconductor transistor die disposed above the carrier, at least one semiconductor diode die disposed above the carrier in a lateral relationship with the semiconductor transistor, and an encapsulation layer. The semiconductor transistor is electrically connected with the semiconductor diode die by means of bond wires or by electrical via connections formed in the encapsulation layer. However, these albeit very short electrical interconnections are associated with undesirable parasitic inductances that can affect the switching speed of the device.

One solution could be to not arrange transistor and diode laterally next to each other but to provide a vertical chip-to-chip stack. However, this requires the provision of suitable materials and interconnect technologies for the interconnect layers within the stack.

For these and other reasons there is a need for the present disclosure.

### SUMMARY

A first aspect of the present disclosure is related to a method for fabricating a semiconductor device, comprising
providing a substrate layer stack comprising a substrate with a metallic upper surface, a first Ni containing layer disposed on the substrate, and a first Sn layer on the first Ni containing layer;
depositing a first semiconductor layer stack on the first Sn layer, the first semiconductor layer stack comprising a first NiP layer, a first semiconductor die disposed on the first NiP layer, and a second NiP layer disposed on the first semiconductor die;
depositing a second semiconductor layer stack on the first semiconductor layer stack, the second semiconductor layer stack comprising
a second Sn layer, a second Ni containing layer disposed on the second Sn layer, and a second semiconductor die disposed on the second Ni containing layer; and
performing a diffusion soldering process for connecting the first semiconductor layer stack to the substrate and the second semiconductor layer stack to the first semiconductor layer stack.

A second aspect of the present disclosure is related to a semiconductor device comprising a substrate comprising a metallic upper surface, a first intermetallic compound layer disposed on the substrate, the first intermetallic compound layer comprising Ni, Sn and P, a first semiconductor die disposed on the first intermetallic compound layer, a second intermetallic compound layer disposed on the first semiconductor die, the second intermetallic compound layer comprising Ni, Sn and P, a second semiconductor die disposed on the second intermetallic compound layer die.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows a flow diagram illustrating an example of a method for fabricating a semiconductor device according to the first aspect.
Fig. 2 shows a cross-sectional side view for illustrating a first example of a method for fabricating a semiconductor device according to the first aspect.
Fig. 3 shows a cross-sectional side view of an example of a semiconductor device according to the second aspect.
Fig. 4 shows a cross-sectional side view for illustrating a second example of a method for fabricating a semiconductor device according to the first aspect.
Fig. 5 shows a cross-sectional side view of an example of a semiconductor device according to the second aspect.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

Moreover, the word "exemplary" is used herein to mean serving as an example, instance, or illustration. Any aspect or design described herein as "exemplary" is not necessarily to be construed as advantageous over other aspects or designs. Rather, use of the word exemplary is intended to present concepts in a concrete fashion. As used in this application, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims may generally be construed to mean "one or multiple" unless specified otherwise or clear from context to be directed to a singular form. Also, at least one of A and B or the like generally means A or B or both A and B.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

### DETAILED DESCRIPTION

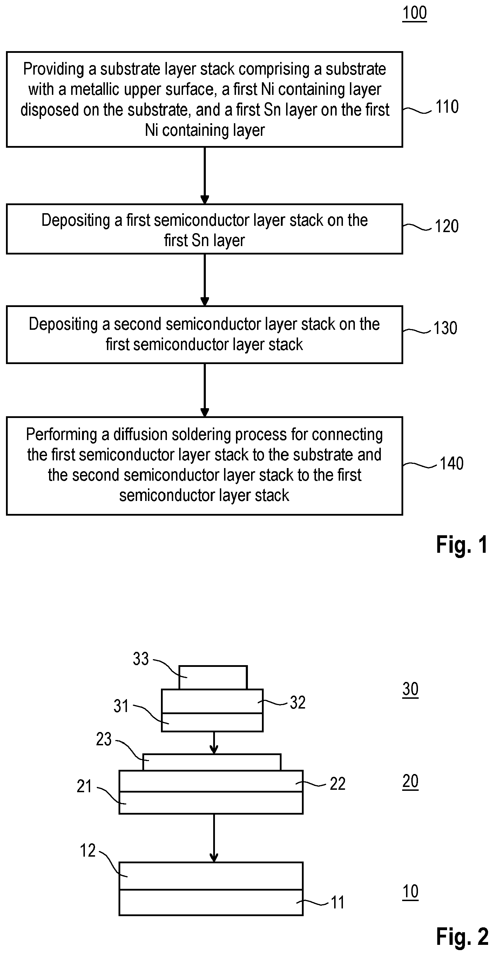

Fig. 1 shows a flow diagram illustrating an example of a method for fabricating a semiconductor device according to the first aspect.

More specifically, the method 100 of Fig. 1 comprises providing a substrate layer stack comprising a substrate with a metallic upper surface, a first Ni containing layer disposed on the substrate, and a first Sn layer on the first Ni containing layer (110);
depositing a first semiconductor layer stack on the first Sn layer, the first semiconductor layer stack comprising a first NiP layer, a first semiconductor die disposed on the first NiP layer, and a second NiP layer disposed on the first semiconductor die (120);
depositing a second semiconductor layer stack on the first semiconductor layer stack, the second semiconductor layer stack comprising
a second Sn layer, a second Ni containing layer disposed on the second Sn layer, and a second semiconductor die disposed on the second Ni containing layer (130); and
performing a diffusion soldering process for connecting the first semiconductor layer stack to the substrate and the second semiconductor layer stack to the first semiconductor layer stack (140).

According to an embodiment of the method of Fig. 1, the first semiconductor layer stack is a semiconductor diode layer stack, wherein the first semiconductor die is a semiconductor diode die, and the second semiconductor layer stack is a semiconductor transistor layer stack, wherein the second semiconductor die is a semiconductor transistor die.

This embodiment described above will be the subject of Figures 2 to 5.

However, the reverse embodiment is also conceivable, in which the first semiconductor layer stack is a semiconductor transistor layer stack, wherein the first semiconductor die is a semiconductor transistor die, and the second semiconductor layer stack is a semiconductor diode layer stack, wherein the second semiconductor die is a semiconductor diode die.

According to an embodiment of the method of Fig. 1, the first semiconductor layer stack further comprises a first Pd layer disposed on the first NiP layer on a side remote from the first semiconductor die, and a second Pd layer disposed on the second NiP layer on a side remote from the first semiconductor die.

According to an embodiment of the method of Fig. 1, one or both of the first and second Ni containing layers comprise a Ni layer or a NiV layer.

According to an embodiment of the method of Fig. 1, a thickness of the first and second Ni containing layers is in a range from 300 nm to 500 nm.

According to an embodiment of the method of Fig. 1, a thickness of the first and second Sn layers is in a range from 1100 nm to 1600 nm.

According to an embodiment of the method of Fig. 1, a thickness of the first and second NiP layers is in a range from 200 nm to 500 nm.

According to an embodiment of the method of Fig. 1, the substrate is one or more of a leadframe, a direct bonded copper (DCB), and active metal braze (AMB), an insulated metal substrate (IMS), or a copper layer deposited on SiO2 substrate.

According to an embodiment of the method of Fig. 1, the semiconductor transistor die can in particular be a power semiconductor transistor die. Here, the term "power semiconductor transistor die" may refer to a semiconductor die providing at least one of high voltage blocking or high current-carrying capabilities. A power semiconductor die may be configured for high currents having a maximum current value of a few Amperes, such as e.g. 10 A, or a maximum current value of up to or exceeding 100 A. Similarly, voltages associated with such current values may have values of a few Volts to a few tens or hundreds or even thousands of Volts.

The semiconductor device described here may e.g. comprise semiconductor transistor dies comprising MOS transistor structures or vertical transistor structures like, for example, IGBT (Insulated Gate Bipolar Transistor) structures or, in general, transistor structures in which at least one electrical contact pad is arranged on a first main face of the semiconductor chip and at least one other electrical contact pad is arranged on a second main face of the semiconductor die, opposite to the first main face.

In general, semiconductor dies as described herein may be manufactured from an elemental semiconductor material (e.g. Si) or from a wide band gap semiconductor material or a compound semiconductor material (e.g. SiC, GaN, SiGe, GaAs).

Fig. 2 shows a cross-sectional side view for illustrating a first example of a method for fabricating a semiconductor device according to the first aspect.

As shown in Fig. 2, the method comprises prefabricating three different layer stacks before joining them together in a diffusion soldering process.

More specifically, the method as illustrated in Fig. 2 comprises providing a substrate layer stack 10 comprising a copper leadframe 11, and a first compound layer 12 disposed on an upper main surface of the leadframe 11, the first compound layer 12 comprising a first Ni containing layer disposed on the leadframe 11 and a first Sn layer disposed on the first Ni containing layer.

The method as illustrated in Fig. 2 further comprises providing a semiconductor diode layer stack 20 comprising a first NiP layer 21, a semiconductor diode die 22 disposed on the first NiP layer 21, and a second NiP layer 23 disposed on the semiconductor diode die 22. The first NiP layer 21 and the second NiP layer 23 can be both comprised of alloys of Ni and P.

The method as illustrated in Fig. 2 further comprises providing a semiconductor transistor layer stack 30 comprising a second compound layer 31 comprising a second Sn layer and a second Ni containing layer disposed on the second Sn layer. The semiconductor transistor layer stack 30 further comprises an IGBT die 32 disposed on the second compound layer 31, and a frontside metal layer 33 disposed on an upper main surface of the IGBT die 32.

As indicated by the arrows in Fig. 2, the semiconductor diode layer stack 20 is placed onto the substrate layer stack 10, and the semiconductor transistor layer stack 30 is placed onto the semiconductor diode layer stack 20. Then a die attach process is carried out wherein the semiconductor diode layer stack 20 is soldered to the substrate layer stack 10 and the semiconductor transistor layer stack 30 is soldered to the semiconductor diode layer stack 20. This can be carried out by placing e.g. the whole assembly in a diffusion oven and performing a diffusion soldering process in a temperature range between 350°C and 380°C.

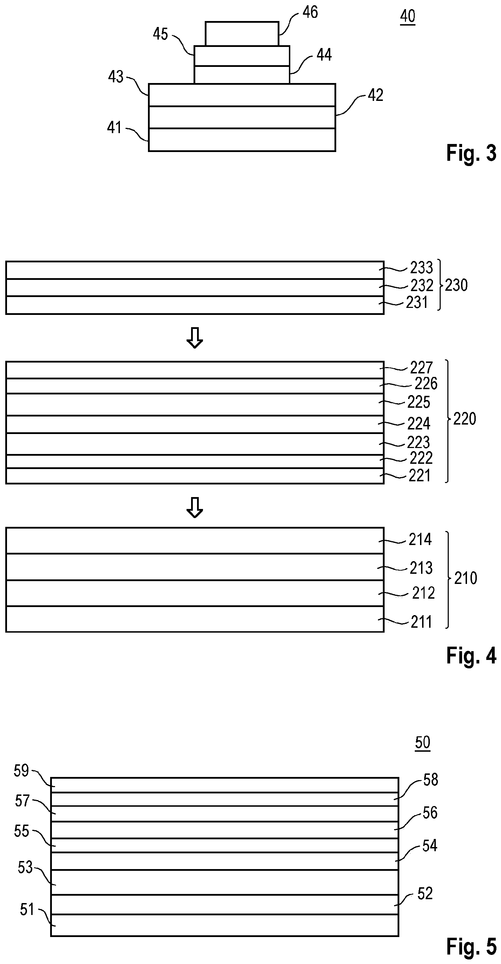

Fig. 3 shows a cross-sectional side view of an example of a semiconductor device according to the second aspect.

The semiconductor device 40 as shown in Fig. 3 comprises a substrate 41 comprising a metallic upper surface, a first intermetallic compound layer 42 disposed on the substrate 41, the first intermetallic compound layer 42 comprising Ni, Sn and P, a first semiconductor die 43 disposed on the first intermetallic compound layer 42, a second intermetallic compound layer 44 disposed on the first semiconductor die 43, the second intermetallic compound layer 44 comprising Ni, Sn and P, and a second semiconductor die 45 disposed on the second intermetallic compound layer 44.

The semiconductor device 40 as shown in Fig. 3 can be one fabricated according to the method as illustrated in Fig. 2. Accordingly, the substrate 41 corresponds to the substrate 11 of Fig. 2, the first semiconductor die 43 corresponds to the semiconductor diode die 22 of Fig. 2, the second semiconductor die 45 corresponds to the semiconductor transistor die 32 of Fig. 2, and the frontside metal layer 46 corresponds to the frontside metal layer 33 of Fig. 2.

More important, the first intermetallic compound layer 42 and the second intermetallic compound layer 44 result from diffusion soldering processes as described above in connection with Fig. 2. More specifically, the first intermetallic compound layer 42 comprising Ni, Sn and P is a result of the diffusion soldering process of the Ni and Sn layers of the substrate layer stack 10 and the first NiP layer 21 of the first semiconductor layer stack 20. Furthermore, the second intermetallic compound layer 44 comprising Ni, Sn and P is a result of the diffusion soldering process of the second NiP layer 23 of the first semiconductor layer stack 20 and the compound layer 32 with the Ni and Sn layers of the second semiconductor layer stack 30.

Fig. 4 shows a cross-sectional side view for illustrating a second example of a method for fabricating a semiconductor device according to the first aspect.

As shown in Fig. 4, the method comprises prefabricating three different layer stacks before joining them together in a diffusion soldering process.

More specifically, the method as illustrated in Fig. 4 comprises providing a substrate layer stack 210 comprising a glass plate 211, a copper layer 212 deposited on the glass plate 211, a NiV layer 213 disposed on the copper layer 212, and an Sn layer 214 disposed on the NiV layer 212. The glass plate 211 can be made of a glass wafer. Alternatively it can also be made of a Si wafer.

The method as illustrated in Fig. 4 further comprises providing a semiconductor diode layer stack 220 comprising a first Pd or Au layer 221, a first NiP layer 222 disposed on the first Pd or Au layer 221, a first metal contact layer 223, a semiconductor diode die 224 disposed on the first metal contact layer 223, a second metal contact layer 225 disposed on the semiconductor diode die 224, a second NiP layer 226 disposed on the second metal contact layer 225, and a second Pd or Au layer 227 disposed on the second NiP layer 226. The first NiP layer 222 and the second NiP layer 224 can be both comprised of alloys of Ni and P. The first metal contact layer 223 and the second metal contact layer 225 can be comprised of Cu or alloys of AlSiCu, AlCu, or AlSi.

The method as illustrated in Fig. 4 further comprises providing a semiconductor transistor layer stack 230 comprising a NiSn layer stack 231 which may comprise a subsequent order of layers of Al, Ti, NiV and Sn. 2The semiconductor transistor layer stack 230 further comprises an IGBT die 232 disposed on the NiSn layer stack 231, and a frontside metal layer 233 disposed on an upper main surface of the IGBT die 232.

As indicated by the arrows in Fig. 4, the semiconductor diode layer stack 220 is placed onto the substrate layer stack 210, and the semiconductor transistor layer stack 230 is placed onto the semiconductor diode layer stack 220. Then a die attach process is carried out wherein the semiconductor diode layer stack 220 is soldered to the substrate layer stack 210 and the semiconductor transistor layer stack 230 is soldered to the semiconductor diode layer stack 220. This can be carried out by placing e.g. the whole assembly in a diffusion oven and performing a diffusion soldering process in a temperature range between 350°C and 380°C.

Fig. 5 shows a cross-sectional side view of an example of a semiconductor device according to the second aspect.

The semiconductor device 50 as shown in Fig. 5 comprises a glass substrate 51, a copper layer 52 disposed on the glass substrate 51, a first intermetallic compound layer 53 disposed on the copper layer 52, the first intermetallic compound layer 53 comprising Ni, V, Sn, P, and Pd or Au, a first metal contact layer 54 disposed on the first intermetallic compound layer 53, a semiconductor diode die 55 disposed on the first metal contact layer 54, a second metal contact layer 56 disposed on the semiconductor diode die 55, a second intermetallic compound layer 57 disposed on the second metal contact layer 56, a semiconductor IGBT die 58 disposed on the second intermetallic compound layer 57, and a frontside metal layer 59 disposed on the semiconductor IGBT die 58.

The semiconductor device 50 as shown in Fig. 5 can be one fabricated according to the method as illustrated in Fig. 4. Accordingly, the substrate 51 may correspond to the substrate 211 of Fig. 4, the semiconductor diode die 55 may correspond to the semiconductor diode die 224 of Fig. 4, the semiconductor transistor die 58 may correspond to the semiconductor transistor die 232 of Fig. 4, and the frontside metal layer 59 may correspond to the frontside metal layer 233 of Fig. 4.

More important, the first intermetallic compound layer 52 and the second intermetallic compound layer 57 may result from diffusion soldering processes as described above in connection with Fig. 4. More specifically, the first intermetallic compound layer 52 comprising Ni, V, Sn, P, and Pd or Au maybe a result of the diffusion soldering process of the NiV and Sn layers of the substrate layer stack 210 and the first Pd or Au layer 221 and the first NiP layer 21 of the first semiconductor layer stack 20. Furthermore, the second intermetallic compound layer 57 comprising NiV, Sn, P, Al, and Pd or Au maybe a result of the diffusion soldering process of the second NiP layer 226 and the Pd or Au layer 227 of the semiconductor diode layer stack 220 and the NiSn layer stack 231 of the second semiconductor layer stack 230.

It is possible to fabricate a plurality of semiconductor devices, in particular identical semiconductor devices, by providing a large substrate like e.g. a glass or Si wafer or a leadframe and to fabricate a plurality of semiconductor devices in a parallel manner.

### EXAMPLES

In the following specific examples of the present disclosure are described.

Example 1 is a method for fabricating a semiconductor device, the method comprising providing a substrate layer stack comprising a substrate with a metallic upper surface, a first Ni containing layer disposed on the substrate, and a first Sn layer on the first Ni containing layer, depositing a first semiconductor layer stack on the first Sn layer, the first semiconductor layer stack comprising a first NiP layer, a first semiconductor die disposed on the first NiP layer, and a second NiP layer disposed on the first semiconductor die, depositing a second semiconductor layer stack on the first semiconductor layer stack, the second semiconductor layer stack comprising a second Sn layer, a second Ni containing layer disposed on the second Sn layer, and a second semiconductor die disposed on the second Ni containing layer, and performing a diffusion soldering process for connecting the first semiconductor layer stack to the substrate and the second semiconductor layer stack to the first semiconductor layer stack.

Example 2 is the method according to Example 1, wherein the first semiconductor layer stack is a semiconductor diode layer stack, wherein the first semiconductor die is a semiconductor diode die, and the second semiconductor layer stack is a semiconductor transistor layer stack, wherein the second semiconductor die is a semiconductor transistor die.

Example 3 is the method according to Example 1, wherein the first semiconductor layer stack is a semiconductor transistor layer stack, wherein the first semiconductor die is a semiconductor transistor die, and the second semiconductor layer stack is a semiconductor diode layer stack, wherein the second semiconductor die is a semiconductor diode die.

Example 4 is the method according to any one of the preceding Examples, wherein the first semiconductor layer stack further comprises a first Pd layer disposed on the first NiP layer on a side remote from the first semiconductor die, and a second Pd layer disposed on the second NiP layer on a side remote from the first semiconductor die.

Example 5 is the method according to any one of the preceding Examples, wherein one or both of the first and second Ni containing layers comprise a Ni layer or a NiV layer.

Example 6 is the method according to any one of the preceding Examples, wherein a thickness of the first and second Ni containing layers is in a range from 300 nm to 500 nm.

Example 7 is the method according to any one of the preceding Examples, wherein a thickness of the first and second Sn layers is in a range from 1100 nm to 1600 nm.

Example 8 is the method according to any one of the preceding Examples, wherein a thickness of the first and second NiP layers is in a range from 200 nm to 500 nm.

Example 9 is the method according to any one of the preceding Examples, wherein the substrate is one or more of a leadframe, a direct bonded copper (DCB), and active metal braze (AMB), an insulated metal substrate (IMS), or a copper layer deposited on SiO2 substrate.

Example 10 is a semiconductor device, comprising a substrate comprising a metallic upper surface, a first intermetallic compound layer disposed on the substrate, the first intermetallic compound layer comprising Ni, Sn and P, a first semiconductor die disposed on the first intermetallic compound layer, a second intermetallic compound layer disposed on the first semiconductor die, the second intermetallic compound layer comprising Ni, Sn and P, a second semiconductor die disposed on the second intermetallic compound layer die.

Example 11 is the semiconductor device according to Example 10, wherein the first semiconductor die is a semiconductor diode die, and the second semiconductor die is a semiconductor transistor die.

Example 12 is the semiconductor device according to Example 10, wherein the first semiconductor die is a semiconductor transistor die, and the second semiconductor die is a semiconductor diode die.

Example 13 is the semiconductor device according to any one of Examples 10 to 12, wherein the first intermetallic compound layer further comprises one or more of V, Pd and Au.

Example 14 is the semiconductor device according to any one of Examples 10 to 13, wherein the second intermetallic compound layer further comprises one or more of Pd, Au, Al, and Ti.

Example 15 is the semiconductor device according to any one of Examples 10 to 14, wherein the substrate is one or more of a leadframe, a direct bonded copper (DCB), and active metal braze (AMB), an insulated metal substrate (IMS), or a copper layer deposited on SiO2 substrate.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method (100) for fabricating a semiconductor device, the method comprising
providing a substrate layer stack comprising a substrate with a metallic upper surface, a first Ni containing layer disposed on the substrate, and a first Sn layer on the first Ni containing layer (110);
depositing a first semiconductor layer stack on the first Sn layer, the first semiconductor layer stack comprising
a first NiP layer, a first semiconductor die disposed on the first NiP layer, and a second NiP layer disposed on the first semiconductor die (120);
depositing a second semiconductor layer stack on the first semiconductor layer stack, the second semiconductor layer stack comprising
a second Sn layer, a second Ni containing layer disposed on the second Sn layer, and a second semiconductor die disposed on the second Ni containing layer (130); and
performing a diffusion soldering process for connecting the first semiconductor layer stack to the substrate and the second semiconductor layer stack to the first semiconductor layer stack (140).

2. The method (100) according to claim 1, wherein
the first semiconductor layer stack is a semiconductor diode layer stack, wherein the first semiconductor die is a semiconductor diode die, and
the second semiconductor layer stack is a semiconductor transistor layer stack, wherein the second semiconductor die is a semiconductor transistor die.

3. The method (100) according to claim 1, wherein
the first semiconductor layer stack is a semiconductor transistor layer stack, wherein the first semiconductor die is a semiconductor transistor die, and
the second semiconductor layer stack is a semiconductor diode layer stack, wherein the second semiconductor die is a semiconductor diode die.

4. The method (100) according to any one of the preceding claims, wherein
the first semiconductor layer stack further comprises a first Pd layer disposed on the first NiP layer on a side remote from the first semiconductor die, and
a second Pd layer disposed on the second NiP layer on a side remote from the first semiconductor die.

5. The method (100) according to any one of the preceding claims, wherein
one or both of the first and second Ni containing layers comprise a Ni layer or a NiV layer.

6. The method (100) according to any one of the preceding claims, wherein
a thickness of the first and second Ni containing layers is in a range from 300 nm to 500 nm.

7. The method (100) according to any one of the preceding claims, wherein
a thickness of the first and second Sn layers is in a range from 1100 nm to 1600 nm.

8. The method (100) according to any one of the preceding claims, wherein
a thickness of the first and second NiP layers is in a range from 200 nm to 500 nm.

9. The method (100) according to any one of the preceding claims, wherein
the substrate is one or more of a leadframe, a direct bonded copper (DCB), and active metal braze (AMB), an insulated metal substrate (IMS), or a copper layer deposited on SiO2 substrate.

10. A semiconductor device (10; 20), comprising
- a substrate (11; 21) comprising a metallic upper surface;
- a first intermetallic compound layer disposed on the substrate, the first intermetallic compound layer comprising Ni, Sn and P;
- a first semiconductor die disposed on the first intermetallic compound layer;
- a second intermetallic compound layer disposed on the first semiconductor die, the second intermetallic compound layer comprising Ni, Sn and P;
- a second semiconductor die disposed on the second intermetallic compound layer die.

11. The semiconductor device (10; 20) according to claim 10, wherein
the first semiconductor die is a semiconductor diode die; and the second semiconductor die is a semiconductor transistor die.

12. The semiconductor device (10; 20) according to claim 10, wherein
the first semiconductor die is a semiconductor transistor die, and
the second semiconductor die is a semiconductor diode die.

13. The semiconductor device (10; 20) according to any one of claims 10 to 12, wherein
the first intermetallic compound layer further comprises one or more of V, Pd and Au.

14. The semiconductor device (10; 20) according to any one of claims 10 to 13, wherein
the second intermetallic compound layer further comprises one or more of Pd, Au, Al, and Ti.

15. The semiconductor device (10; 20) according to any one of claims 10 to 14, wherein
the substrate is one or more of a leadframe, a direct bonded copper (DCB), and active metal braze (AMB), an insulated metal substrate (IMS), or a copper layer deposited on SiO2 substrate.
